# EUROPEAN PATENT SPECIFICATION

(11) **EP 3 041 325 B1**
(45) Date of publication and mention of the grant of the patent: **09.03.2022**
(21) Application number: 15170387.3
(22) Date of filing: 03.06.2015
(51) Int. Cl.: H05K 1/11, H05K 1/18

(54) **BACK LIGHT UNIT AND LIQUID CRYSTAL DISPLAY DEVICE USING THE SAME**
RÜCKBELEUCHTUNGSEINHEIT UND FLÜSSIGKRISTALLANZEIGEVORRICHTUNG DAMIT
DISPOSITIF D'AFFICHAGE À CRISTAUX LIQUIDES UTILISANT CELLE-CI

(30) Priority: 29.12.2014 KR 20140192207
(43) Date of publication of application: 06.07.2016
(73) Proprietor: LG Display Co., Ltd., Seoul 150-721 (KR)
(72) Inventor: Jung, Yeoun Jei, 704-766 Daegu (KR)
(74) Representative: Viering, Jentschura & Partner mbB Patent- und Rechtsanwälte

(56) References cited:
- JP-A- 2011 244 006
- US-A- 5 831 701
- US-A1- 2007 015 378
- US-A1- 2008 074 902
- US-A1- 2010 110 327
- US-A1- 2010 220 496
- US-A1- 2010 326 704
- US-A1- 2012 169 958
- US-A1- 2013 141 667
- US-A1- 2013 186 680
- US-A1- 2013 188 394
- US-A1- 2014 226 080
- US-A1- 2014 374 148

## Description

### CROSS REFERENCE TO RELATED APPLICATIONS

This application claims the benefit of the Korean Patent Application No. 10-2014-0192207 filed on December 29, 2014.

### BACKGROUND OF THE INVENTION

### Field of the Invention

The present invention relates to a back light unit and a liquid crystal display device using the same.

### Discussion of the Related Art

Flat panel displays (FPD) have been used for various kinds of electronic products including cellular phones, tablet PCs, and notebook computers. Examples of the flat panel displays include Liquid Crystal Display Device (LCD), Plasma Display Panel (PDP), and Organic Light Emitting Display Device (OLED). Recently, Electrophoretic Display (EPD) has been widely used as the flat panel display.

The LCD of the flat panel displays has been commercially used most widely owing to its advantages such as mass production technique, facilitation of a driving means, and realization of high picture quality.

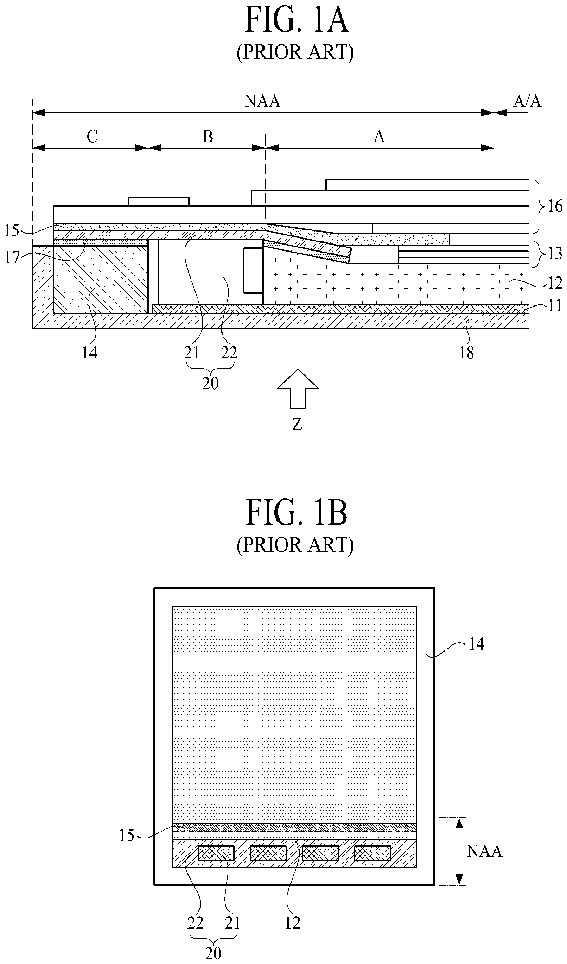

FIG. 1a is an exemplary view illustrating a cross-section of an LCD according to the related art. FIG. 1b is an exemplary view illustrating a bottom of an LCD according to the related art. Particularly, FIG. 1b illustrates a bottom of an LCD in a direction 'Z' of FIG. la.

The LCD according to the related art, as shown in FIG. 1a, includes a reflecting plate 11, a light guide panel 12, an optical film module 13, a guide panel 14, a liquid crystal panel 16, a light-shielding tape 15, and a light source module 20.

The light source module 20 includes a flexible printed circuit board (FPCB) 21 and a light source 22. The flexible printed circuit board 21 is attached to the guide panel 14, the light source 22 and the light guide panel 12 by an adhesive tape 17. The guide panel 14 may be supported by a cover bottom 18.

As the liquid crystal panel 16 is attached to the light source module 20, the light guide panel 12 and the optical film module 13 by the light-shielding tape 15, the LCD is completed.

Recently, studies for reducing a width of an outer portion (hereinafter, simply referred to as 'bezel') of the LCD have been actively made.

However, as shown in FIGS. 1a and 1b, according to the related art, the guide panel 14 is provided in a rectangular frame type, and the light source module 20 is arranged at a bezel area NAA of the guide panel 14, whereby there is a limitation in reducing the width of the bezel are NAA of the LCD.

For example, the bezel area NAA of the LCD according to the related art includes a first area A extending from an outer portion of a display area A/A, from which an image is output, to an outer portion of the light guide panel 12, a second area B extending from the first area A to the guide panel 14, and a third area C corresponding to a thickness of the guide panel 14 and the cover bottom 18.

Since each of the above areas performs its unique function, it is difficult for any one of the areas to be removed randomly, or it is difficult for a width of any one of the areas to be changed randomly. Therefore, it is difficult for the width of the bezel area NAA where the light source module 20 is arranged to be reduced.

US 2013/141667 A1 describes that a liquid crystal display device includes a reflection plate; a light guide plate over the reflection plate; a light-emitting diode (LED) assembly including LEDs arranged along a side surface of the light guide plate, an LED flexible printed circuit board (FPCB) having LEDs mounted on its surface. The FPCB includes a bar and a leg portion extending from the body. The bar and the leg portion are integrated into a single body. The leg portion extends from the bar to a circuit for controlling the LEDs. A metallic bar is attached to bar of the LED FPCB to provide rigidity to the FPCB as well as cool the FPCB.

US 2013/186680 A1 describes that a tape film package is provided including an insulating pattern; a via contact in a via hole in the insulating pattern; first interconnection patterns extending from the via contact to a cutting surface of the insulating pattern; and second interconnection patterns connected to the via contact below the insulating pattern. The second interconnection patterns are parallel to the first interconnection patterns and spaced apart from the cutting surface of the insulating pattern.

US 2007/0015378 A1 describes that a flexible printed circuit board includes a flexible substrate, which has a bonding zone, a folding zone, and a folding line between the bonding zone and the folding zone, two electrically conductive contacts respectively located at the bonding zone, two lead wires each having an extension portion respectively electrically connected to the electrically conductive contacts and arranged in parallel to the folding line and a connecting portion extending integrally from the extension portion toward the folding zone, and a protective layer covered on the flexible substrate over the lead wires. The protective layer has openings corresponding to the electrically conductive contacts.

US 2012/169958 A1 discloses a back light unit comprising a guide panel of which a lateral side is opened and a bottom side is opened; a light guide panel arranged in the guide panel; a cover bottom configured to support the guide panel; and a light source module arranged at the lateral side of the guide panel.

### SUMMARY OF THE INVENTION

The present invention is defined in independent claim 1. Further preferred embodiments are defined in the dependent claims.

Additional advantages and features of the invention will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIG. 1a is an exemplary view illustrating a cross-section of an LCD according to the related art;
FIG. 1b is an exemplary view illustrating a bottom of an LCD according to the related art;
FIG. 2 is an exploded perspective view illustrating an LCD according to the present invention;
FIG. 3 is an exemplary view illustrating a cross-section of an LCD according to the present invention;
FIG. 4 is an exemplary view illustrating a bottom of an LCD according to the present invention;
FIG. 5 is an exemplary view illustrating a comparison between light source modules to which a flexible printed circuit board according to embodiments of the present invention is applied and a light source module to which a flexible printed circuit board of the related art is applied;
FIG. 6 is an exemplary view illustrating a portion where an extension substrate of a flexible printed circuit board according to embodiments of the present invention projects from a main portion of a substrate of the flexible printed circuit board; and
FIG. 7 is another exemplary view illustrating a portion where an extension substrate of a flexible printed circuit board according to embodiments of the present invention projects from a main portion of a substrate of the flexible printed circuit board.

### DETAILED DESCRIPTION OF THE INVENTION

Reference will now be made in detail to the exemplary embodiments of the present invention, examples of which are illustrated in the accompanying drawings. Wherever possible, the same reference numbers will be used throughout the drawings to refer to the same or like parts.

Hereinafter, the embodiment of the present invention will be described in detail with reference to the accompanying drawings.

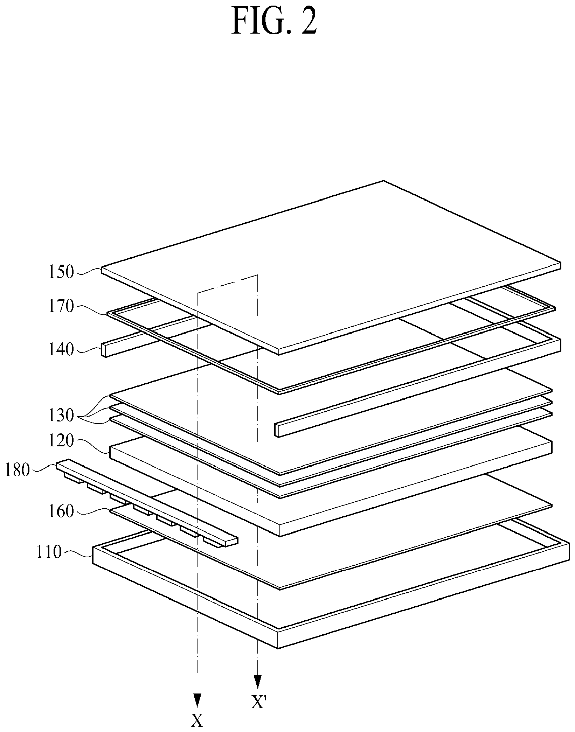

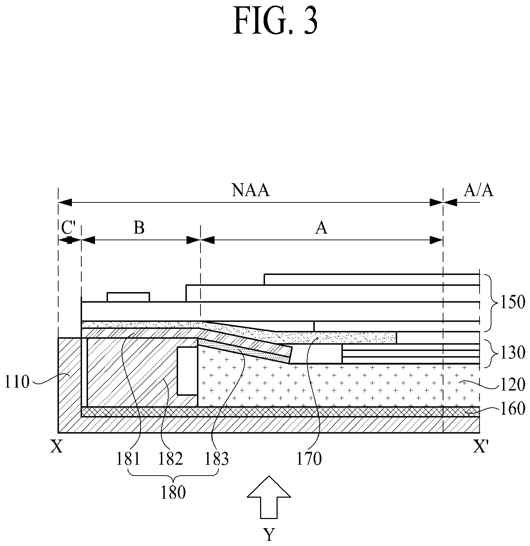

FIG. 2 is an exploded perspective view illustrating an LCD according to the present invention. FIG. 3 is an exemplary view illustrating a cross-section of an LCD according to the present invention, especially illustrating a cross-section taken along line X-X' of FIG. 2.

The LCD according to the present invention, as shown in FIGS. 2 and 3, includes a liquid crystal panel 150, and a back light unit supporting the liquid crystal panel 150 and irradiating light to the liquid crystal panel 150. The back light unit includes a guide panel 140 of which a lateral side (or end) is opened, and a light source module 180 arranged at the lateral side (or end) of the guide panel 140, irradiating light.

First of all, the liquid crystal panel 150 includes a liquid crystal injected between an array substrate and a color filter substrate, and outputs image by controlling transmittance of light emitted from the light source module.

A polarizing film may be attached to an upper end surface (also referred to as top surface) and a lower end surface (also referred to as bottom surface) of the liquid crystal panel 150. The polarizing film is attached to at least one of the upper end surface and the lower end surface of the liquid crystal panel 150, and serves to pass through only specific directional components among components of the light transferred through a light guide panel 120.

Second, the back light unit includes a light-shielding tape 170 attached to the lower end surface of the liquid crystal panel 150, the light source module 180, the guide panel 140, an optical film module 130 comprised of a plurality of optical sheets, a light guide panel 120 irradiating the light output from the light source module 180 toward the liquid crystal panel 150, a reflecting plate 160 arranged on the bottom of the light guide panel, and a cover bottom 110 (also referred to as bottom cover) supporting the guide panel.

First of all, the light-shielding tape 170 is formed in a shape of a rectangular frame as shown in FIG. 2, and is attached to a lower end surface of an outer portion (hereinafter, simply referred to as 'bezel') of the liquid crystal panel 150 and an upper end surface of the guide panel 140. The light-shielding tape 170 may be formed in various shapes depending on a shape of the liquid crystal panel 150.

The light-shielding tape 170 prevents the light transmitted from the light source module 180 from leaking between the guide panel 140 and the liquid crystal panel 150, and also prevents the light from leaking through the bezel.

Next, the guide panel 140 is formed in a shape of a rectangular frame, whereby the bezel of the liquid crystal panel 150 is arranged.

Particularly, a lateral side (or end) of the guide panel 140 is opened as shown in FIG. 2, wherein the light source module 180 is arranged at the lateral side (or end) of the guide panel 140. If the guide panel 140 is formed in a shape of a rectangular frame, the guide panel 140 is substantially formed in a shape of ' 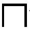 ' ("rectangular horseshoe" shape). In other words, one link of the rectangular frame may be missing.

However, the guide panel 140 may be formed in various shapes depending on a shape of the liquid crystal panel 150. In this case, the lateral side (or end) of the guide panel is opened.

The light-shielding tape 170 is attached to the upper end surface of the guide panel 140.

The guide panel 140 serves to guide the light source module 180.

Next, the light source module 180 is guided by the guide panel 140, and serves to irradiate the light toward a side of the light guide panel.

The light source module 180 includes a flexible printed circuit board 181, and at least two or more light sources 182 placed on the flexible printed circuit board 181.

The flexible printed circuit board 181 is attached to the outer portion of the upper end surface of the light guide panel 120 and the upper end surface of the light sources 182 by an adhesive tape 183.

Various types of lamps may be used as the light sources 182, especially light emitting diodes (LED) may be used as the light sources 182.

Next, the optical film module 130 includes the plurality of optical sheets.

The optical film module 130 serves to diffuse the light that has passed through the light guide panel 120 or allow the light that has passed through the light guide panel 12 to vertically enter the liquid crystal panel 150.

To this end, the optical film module 130 may be formed variously to include a diffuser sheet that diffuses the light, and a prism sheet that converts the light vertically to the liquid crystal panel 150.

Next, the light guide panel 120 irradiates the light output from the light source module 180 toward the liquid crystal panel 150.

The light guide panel (LGP) 120 is formed of a transparent material, and is manufactured in a shape of a panel. The light guide panel 120 serves to transmit the light emitted from the light source module 180 toward the liquid crystal panel 150 arranged on the upper end of the light guide panel 120 by scattering and reflecting the light.

The light guide panel 120 may be formed of a material of plastic or resin, such as PMMA (Polymethylmethacrylate).

Next, the reflecting plate 160 is arranged on the bottom of the light guide panel 120.

The reflecting plate 160 is arranged on the lower end surface of the light guide panel 120, and serves to reflect the light, which is emitted from the light source module 180 and moves toward the lower end of the light guide panel 120, toward the liquid crystal panel 150 arranged on the upper end of the light guide panel 120.

For example, the light, which is emitted from the light source module 180 and enters the light guide panel 120, is refracted by a pattern formed in the light guide panel and reflected toward the liquid crystal panel 150. However, the light, which leaks out through the lower end surface of the light guide panel 120 without being reflected toward the liquid crystal panel 150, may exist. The reflecting plate 160 serves to reflect the light, which leaks out through the lower end surface of the light guide panel 120, toward the light guide panel 120 and guide the light toward the liquid crystal panel 150.

Finally, the cover bottom 110 supports the guide panel 140.

The cover bottom 110 serves to receive the aforementioned elements as well as the guide panel 140.

In this case, the cover bottom 110 may be secured to a case top, which covers the bezel of the liquid crystal panel 150, to receive the aforementioned elements. However, the cover bottom 110 may receive the aforementioned elements independently without the case top.

Also, in the LCD according to the present invention, the cover bottom 110 may be omitted.

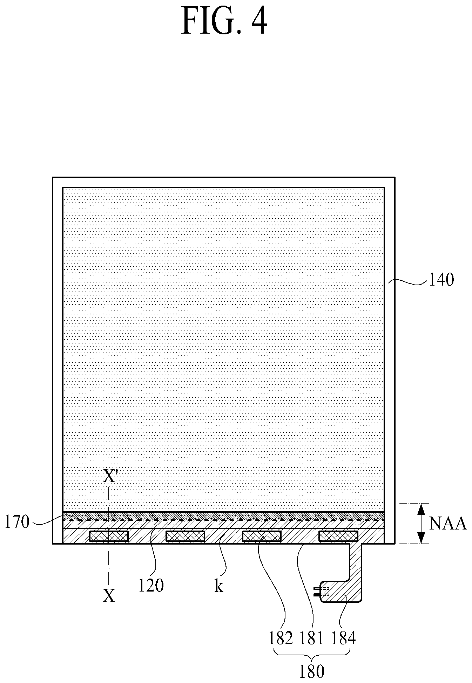

FIG. 4 is an exemplary view illustrating a bottom of an LCD according to the present invention, especially illustrating a bottom of the LCD in a direction Y of FIG. 3. Also, in the LCD shown in FIG. 4, the reflecting plate 160 and the cover bottom 110, which are arranged on the lower end surface of the light guide panel 120, are omitted.

A lateral side (or end) of the guide panel 140 applied to the present invention is opened as shown in FIGS. 2 to 4. The light source module 180 is arranged at the opened lateral side (or end) of the guide panel 140.

In this case, since the lateral side (or end) of the guide panel 140 is opened, a bezel area NAA of the LCD according to the present invention (in other words, an area of the bezel where the light source module 180 is arranged) includes a first area A extending from an outer portion of a display area A/A, from which an image is output, to an outer portion of the light guide panel 120, a second area B extending from the first area A to the cover bottom 110, and a third area C' corresponding to a thickness of the cover bottom 110.

It is noted that the first area A and the second area B of the bezel area NAA of the LCD according to the present invention are almost the same as those of the LCD according to the related art when the bezel area NAA of the LCD according to the present invention is compared with that of the LCD according to the related art shown in FIG. 1.

However, in the LCD according to the present invention, since the lower end of the guide panel 140 is opened, it is noted that a width of the third area C' is reduced in comparison with the third area C of the LCD according to the related art.

In more detail, the width of the third area C of the LCD according to the related art includes a width of the guide panel 140 and a width of the cover bottom 110.

However, the width of the third area C' of the LCD according to the present invention includes only a width of the cover bottom 110.

Therefore, according to the present invention, the third area C' may be reduced, whereby the width of the bezel area NAA may be reduced.

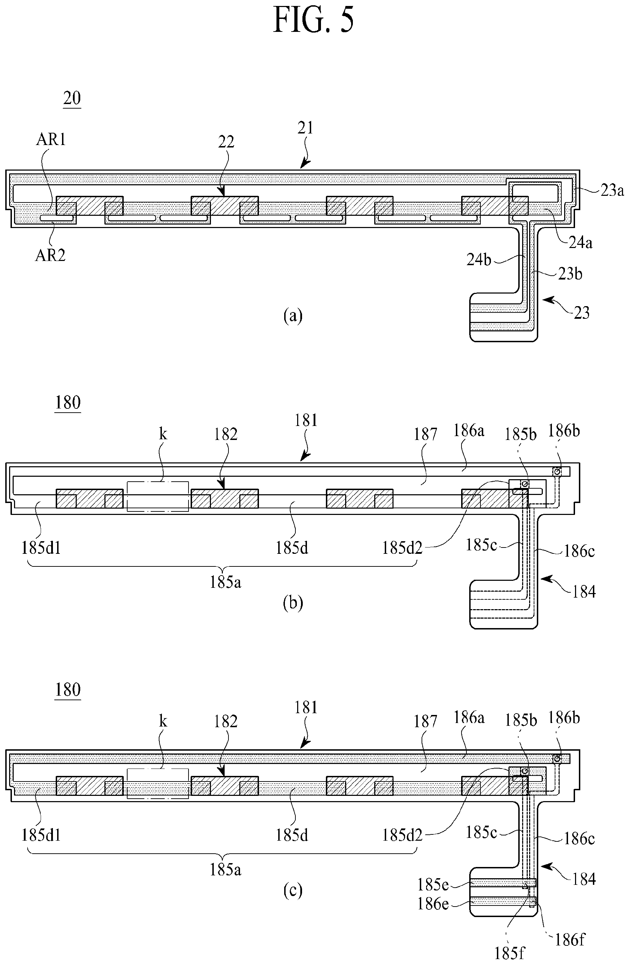

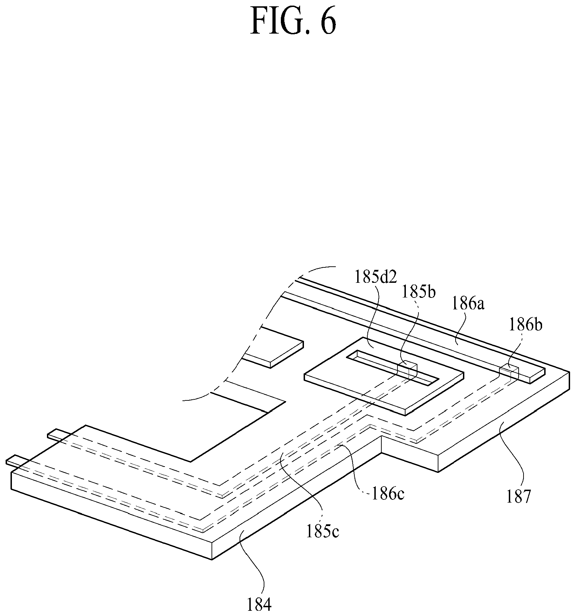

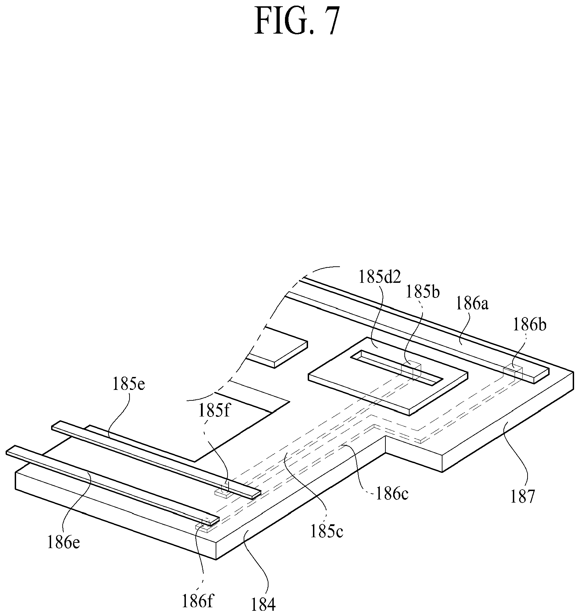

FIG. 5 is an exemplary view illustrating a comparison between light source modules to which a flexible printed circuit board according to embodiments of the present invention is applied and a light source module to which a flexible printed circuit board of the related art is applied. In FIG. 5, (a) illustrates a plane of the light source module 20 to which the flexible printed circuit board 21 of the related art is applied, (b) illustrates a plane of a light source module 180 to which a flexible printed circuit board 181 according to an embodiment of the present invention is applied, and (c) illustrates a plane of a light source module 180 to which a flexible printed circuit board 181 according to another embodiment of the present invention is applied. The light source module 180 to which the flexible printed circuit board 181 according to the embodiment of the present invention shown in (b) or (c) of FIG. 5 is applied may be applied to the LCD according to the present invention shown in FIGS. 2 to 4. FIG. 6 is an exemplary view illustrating a portion where an extension substrate of a flexible printed circuit board according to embodiments of the present invention projects from a main portion of a substrate of the flexible printed circuit board, and FIG. 7 is another exemplary view illustrating a portion where an extension substrate of a flexible printed circuit board according to embodiments of the present invention projects from a main portion of a substrate of the flexible printed circuit board. The views shown in FIG. 6 and FIG. 7 may correspond, respectively, to the embodiments shown in (b) and (c) of FIG. 5.

First of all, as shown in (b) of FIG. 5, the light source module 180 to which the flexible printed circuit board 181 according to embodiments of the present invention is applied includes at least one or more light sources 182 emitting light, and a flexible printed circuit board 181 made of a flexible material, on which the light sources 182 are placed, wherein first and second electrodes 185a and 186a connected to the light sources 182 are arranged on one side (e.g., top side) of the flexible printed circuit board 181 and first and second side electrodes 185c and 186c connected to the first and second electrodes 185a and 186a are arranged on the other side (e.g., bottom side) of the flexible printed circuit board 181.

In this case, the flexible printed circuit board 181 according to embodiments of the present invention includes a substrate 187 made of a flexible material, the first electrode 185a arranged on one side (e.g., top side) of the substrate 187 (also referred to as first side of the substrate), the second electrode 186a arranged on the one side of the substrate 187 and connected to the first electrode 185a, the first side electrode 185c arranged on the other side (e.g., bottom side) of the substrate 187 (also referred to as second side of the substrate) and connected to the first electrode 185a through a first contact hole 185b formed in the substrate 187, and the second side electrode 186c arranged on the other side of the substrate 187 and connected to the second electrode 186a through a second contact hole 186b formed in the substrate 187.

As shown in (b) of FIG. 5, the substrate 187 may include a main portion having a first lateral end and a second lateral end opposite the first lateral end, and a projecting portion projecting from the main portion near the second lateral end. In (b) of FIG. 5, the main portion of the substrate 187 may refer to the elongated portion of the substrate 187 extending from the left side to the right side, and the first lateral end may refer to a left end and the second lateral end may refer to a right end of the elongated portion. The projecting portion may be disposed at an angle of about 90 degrees with respect to the main portion. The first electrode 185a and the second electrode 186a may be disposed on the main portion. The first side electrode 185c and the second side electrode 186c may be disposed on the main portion and on the projecting portion. In other words, a first portion of the first side electrode 185c may be disposed on the main portion of the substrate 187 and a second portion of the first side electrode 185c may be disposed on the projecting portion of the substrate 187. Similarly, a first portion of the second side electrode 186c may be disposed on the main portion of the substrate 187 and a second portion of the second side electrode 186c may be disposed on the projecting portion of the substrate 187.

As further shown in (b) of FIG. 5, the substrate 187 may further include a connecting portion (also referred to as a connection portion) configured to be connected to an external terminal. The connecting portion (connection portion) may be connected to the projecting portion. The connecting portion may extend from the projecting portion. The first side electrode 185c and the second side electrode 186c may extend from the main portion of the substrate 187 via the projecting portion up to an end of the connecting portion. For example, a third portion of the first side electrode 185c and a third portion of the second side electrode 186c may be disposed on the connecting portion. The first side electrode 185c and second side electrode 186c may be disposed on only one side (e.g., the second side, e.g. bottom side) of the substrate 187, as shown. For example, the first, second and third portions of the first side electrode 185c and the first, second and third portions of the second side electrode 186c may all be disposed on the same side of the substrate 187 (e.g., the second side, e.g. bottom side). The connecting portion may be disposed at an angle with respect to the projecting portion, e.g. at an angle of about 90 degrees, as shown. The projecting portion together with the connecting portion may also be referred to as an extension substrate 184 of the flexible printed circuit board 181. The extension substrate 184 may project from the main portion of the substrate 187, as shown.

Each of the first and second electrodes 185a and 186a may be formed of a material having excellent conductivity, such as copper.

Second, the first electrode 185a includes a plurality of electrode patterns 185d, wherein a first one 185d1 of the electrode patterns 185d, which is arranged at the first lateral end of the main portion of the substrate 187, is connected to the second electrode 186a, and a second one 185d2 of the electrode patterns 185d, which is arranged at the second lateral end of the main portion of the substrate 187, is connected to the first side electrode 185c through the first contact hole 185b.

For example, the substrate 187 on which the five electrode patterns 185d are arranged is shown in (b) of FIG. 5.

The first one 185d1 of the electrode patterns 185d, which is arranged at the left end of the main portion of the substrate 187 in (b) of FIG. 5, is connected to the second electrode 186a.

The second one 185d2 of the electrode patterns 185d, which is arranged at the right end of the main portion of the substrate 187 in (b) of FIG. 5, is connected to the first side electrode 185c. In this case, the first side electrode 185c is connected to the second electrode pattern 185d2 through the first contact hole 185b formed in the substrate 187.

In this case, the first electrode 185a that includes the electrode patterns 185d, and the first side electrode 185c are arranged on different surfaces of the substrate 187. Particularly, in (b) of FIG. 5 and FIG. 6, the first electrode 185a is arranged on the first side (e.g. upper end surface or top side) of the substrate 187 while the first side electrode 185c is arranged on the second side (e.g. lower end surface or bottom side) of the substrate 187.

Also, the second side electrode 186c is connected to the second electrode 186a through the second contact hole 186b at an area corresponding to an area of the second electrode 186a in which the second electrode pattern 185d2 is arranged.

In this case, the second electrode 186a and the second side electrode 186c are arranged on different surfaces of the substrate 187. Particularly, in (b) of FIG. 5 and FIG. 6, the second electrode 186a is arranged on the first side (e.g. upper end surface or top side) of the substrate 187 while the second side electrode 186c is arranged on the second side (e.g. lower end surface or bottom side) of the substrate 187.

Third, one light source 182 is in each case electrically connected to two of the electrode patterns 185d, which are adjacent to each other.

Since the electrode patterns 185d are electrically connected to each other, if the light source 182 is electrically connected to the two electrode patterns 185d adjacent to each other, the two electrode patterns 185d serve as + electrode and - electrode, respectively.

Fourth, a light-shielding pad (not shown) for shielding light may be attached to a light-shielding area k between the at least two or more light sources 182 arranged between the electrode patterns 185d, at one side of the substrate 187.

The light-shielding pad is manufactured of a synthetic resin that shields light, and then may be attached to the light-shielding area k by a separate adhesive tape. Alternatively, the light-shielding pad may be formed of an adhesive tape, which shields light, and may directly be attached to the light-shielding area k.

The light-shielding pad may be made of various types of materials having black color or various types of materials that shield light.

Fifth, as shown in FIG. 6, the extension substrate 184 projects from the main portion of the substrate 187 at an area of the main portion of the substrate 187, in which the first side electrode 185c and the second side electrode 186c are arranged.

In this case, the extension substrate 184 is formed in a single body with the main portion of the substrate 187. The extension substrate 184 may include the projecting portion and the connecting portion of the substrate 187. The extension substrate 184 may have an angled shape, for example an "L" shape.

Also, the first side electrode 185c and the second side electrode 186c extend from the main portion of the substrate 187 to the extension substrate 184, for example up to an end of the connecting portion of the substrate 187. The first and second side electrodes 185c, 186c may be disposed on a side of the substrate 187 that is opposite to the side of the substrate 187, on which the first and second electrodes 185a, 186a are disposed. For example, as shown in FIG. 6, if the first electrode 185a and the second electrode 186a are arranged on the first side (e.g. upper end surface or top side) of the substrate 187, the first side electrode 185c and the second side electrode 186c are arranged on the second side (e.g. lower end surface or bottom side) of the substrate 187. That is, in the embodiment shown, the first and and second side electrodes 185c, 186c may be disposed on the second side (e.g., lower end surface or bottom side) of the main portion of the substrate 187 and the second side (e.g., lower end surface or bottom side) of the extension substrate 184 (including the projecting portion and connecting portion of the substrate 187).

According to some embodiments, a portion of the first and second side electrodes 185c, 186c may be disposed on another side of the substrate 187 than remaining portions of the first and second side electrodes 185c, 186c. For example, as shown in (c) of FIG. 5 and the corresponding view of FIG. 7, in accordance with one or more embodiments, a portion 185e of the first side electrode 185c (e.g., a third portion of the first side electrode 185c disposed on the connecting portion of the substrate 187) and a portion 186e of the second side electrode 186c (e.g. a third portion of the second side electrode 186c disposed on the connecting portion of the substrate 187) may be disposed on the first side (e.g. upper end surface or top side) of the substrate 187 (e.g., on the first side of the connecting portion of the substrate 187, as shown) while remaining portions of the first and second side electrodes 185c, 186c (e.g., first and second portions of the first side electrode 185c disposed on the main portion and on the projecting portion of the substrate 187, respectively, and first and second portions of the second side electrode 186c disposed on the main portion and on the projecting portion of the substrate 187, respectively) may be disposed on the second side (e.g. lower end surface or bottom side) of the substrate 187. As shown in (c) of FIG. 5 and in FIG. 7, the connecting portion of the substrate 187 may include a third contact hole 185f and a fourth contact hole 186f, wherein the first side electrode 185c may be connected from the second side of the substrate 187 to the first side of the substrate 187 through the third contact hole 185f, and wherein the second side electrode 186c may be connected from the second side of the substrate 187 to the first side of the substrate 187 through the fourth contact hole 186f.

According to the present invention described as above, the width of the bezel area of the LCD may be reduced.

The characteristics of the present invention described as above are as follows.

First, in order to reduce the size of the bezel area NAA of the LCD, the portion of the guide panel 140, which is arranged in the bezel area NAA, is removed in the present invention.

In the present invention, the guide panel 140 is formed in a shape of ' 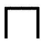 ' ("rectangular horseshoe" shape). That is, the guide panel 140 has a rectangular frame type shape where one of the four links of the frame is missing.

Second, in the present invention, the width of the flexible printed circuit board 181 on which the light source 182 is placed is reduced in comparison with that of the related art. Therefore, the width of the bezel area NAA is reduced.

For example, in the flexible printed circuit board of the related art, as shown in (a) of FIG. 5, a first area AR1 of the upper end surface of the flexible printed circuit board 21, on which the light source is arranged, and a second area AR2 formed on the lower end of the first area AR1 are provided with copper foil patterns.

In this case, the second area AR2 is provided to solve a problem occurring due to a mutual action between the light source 22 and the copper foil patterns. Therefore, if the copper foil patterns provided in the second area AR2 are removed randomly, electrical noise may occur.

Also, if the second area AR2 is removed randomly, it is difficult for the first electrode 24a and the second electrode 23a to be electrically connected with the first side electrode 24b and the second side electrode 23b.

For example, in the flexible printed circuit board 21 of the related art shown in (a) of FIG. 5, the first electrode 24a and the second electrode 23a corresponding to the first electrode 185a and the second electrode 186a of the present invention, and the first side electrode 24b and the second side electrode 23b corresponding to the first side electrode 185c and the second side electrode 186c of the present invention are all arranged on one side of the flexible printed circuit board 21.

Also, the above electrodes are extended to the same surface as the one side of the flexible printed circuit board 21 on the extension substrate 23 extended from the flexible printed circuit board 21. In other words, the first and second electrodes 24a, 23a and the first and second side electrodes 24b, 23b may all be arranged on the same side (e.g., upper end surface).

Therefore, in the flexible printed circuit board 21 of the related art shown in (a) of FIG. 5, if the area corresponding to the second area AR2 is removed, the first side electrode 24b and the second side electrode 23b cannot be arranged in the flexible printed circuit board 21.

However, in the flexible printed circuit board 181 according to one or more embodiments as shown in (b) and (c) of FIG. 5, the area corresponding to the second area AR2 is not provided with copper foil patterns, and the second area AR2 electrically connects the first electrode 185a and the second electrode 186a with the first side electrode 185c and the second side electrode 186c through the first contact hole 185b and the second contact hole 186b without being removed.

Therefore, the second area is removed or its width is reduced to reach a minimum width, whereby the width of the flexible printed circuit board 181 is reduced.

The light-shielding pad is attached to the area between the light sources 182 of the flexible printed circuit board 181 to prevent the light from leaking from the light source module 180.

The width of the bezel area NAA of the LCD is reduced by the aforementioned structure.

As described above, according to the present invention, the following advantages may be obtained.

According to the present invention, as the lateral side (or end) of the guide panel, at which the light source module is arranged, is opened, the width of the bezel area of the LCD that corresponds to the location of the light source module is reduced.

Therefore, according to the present invention, the overall size of the bezel of the LCD is reduced.

## Claims

1. A back light unit comprising:
a guide panel (140) of which a lateral side is completely opened and a bottom side is opened;
a light guide panel (120) arranged in the guide panel (140);
a cover bottom (110) configured to support the guide panel (140), and
a light source module (180) arranged at the lateral side of the guide panel (140), and irradiating light toward a side of the light guide panel (120) arranged at the lateral side of the guide panel (140),
wherein the guide panel (140) is configured to serve to guide the light source module (180),
wherein the light source module (180) comprises:
at least one light source (182) emitting light; and
a flexible printed circuit board (181) on which the light source (182) is placed comprising:
a substrate (187) made of a flexible material;
a first electrode (185a) arranged on a first side of the substrate (187);
a second electrode (186a) arranged on the first side of the substrate (187) and connected to the first electrode (185a);
a first side electrode (185c) arranged on a second side of the substrate (187) and connected to the first electrode (185a) through a first contact hole (185b) formed in the substrate (187), wherein the second side is opposite to the first side; and
a second side electrode (186c) arranged on the second side of the substrate (187) and connected to the second electrode (186a) through a second
contact hole (186b) formed in the substrate (187),
wherein the first and second electrodes (185a, 186a) of the flexible printed circuit board (181) are connected to the light source (182),
wherein the substrate (187) comprises a main portion having a first lateral end and a second lateral end opposite the first lateral end, and a projecting portion projecting from the main portion near the second lateral end, wherein the first electrode (185a) and the second electrode (186a) are disposed on the main portion, wherein the first side electrode (185c) and the second side electrode (186c) are disposed on the main portion and on the projecting portion,
wherein the first electrode (185a) comprises a plurality of electrode patterns (185d),
a first electrode pattern of (185dl) the electrode patterns (185d) is arranged at the first lateral end of the main portion and connected to the second electrode (186a),
a second electrode pattern (185d2) of the electrode patterns (185d) is arranged at the second lateral end of the main portion, and is connected to the first side electrode (185c) through the first contact hole (185b), and
the second side electrode (186c) is connected to the second electrode (186a) through the second contact hole (186b),
wherein the second electrode pattern (185d2) of the electrode patterns (185d) partially overlaps both the first side electrode (185c) and the second side electrode (186c), with the substrate (187) therebetween.

2. The back light unit of claim 1, further comprising a light source (182) disposed between two adjacent electrode patterns (185d) of the plurality of electrode patterns (185d).

3. The back light unit of claim 1, further comprising a plurality of light sources (182), each light source (182) being disposed between two respective adjacent electrode patterns of the plurality of electrode patterns (185d), and a light-shielding pad for shielding light attached between at least two light sources (182) of the plurality of light sources (182).

4. The back light unit of any one of claims 1 to 3, wherein the substrate (187) further comprises a connecting portion configured to be connected to an external terminal and connected to the projecting portion, wherein the first side electrode (185c) and the second side electrode (186c) extend from the main portion via the projecting portion up to an end of the connecting portion.

5. The back light unit of claim 4, wherein the connecting portion comprises a third contact hole (185f) and a fourth contact hole (186c), wherein the first side electrode (185c) is connected from the second side of the substrate (187) to the first side of the substrate (187) through the third contact hole (185f), and wherein the second side electrode (186c) is connected from the second side of the substrate (187) to the first side of the substrate (187) through the fourth contact hole (186f).

6. The back light unit of claim 4 or 5, wherein first and second portions of the first side electrode (185c) corresponding to the main portion and to the projecting portion of the substrate (187), respectively, are disposed on the second side of the substrate (187), a third portion (185e) of the first side electrode (185c) corresponding to the connecting portion of the substrate (187) is disposed on the first side of the substrate (187), and the second portion and the third portion (185e) of the first side electrode (185c) are electrically connected through the third contact hole; and
wherein first and second portions of the second side electrode (186c) corresponding to the main portion and to the projecting portion of the substrate (187), respectively, are disposed on the second side of the substrate (187), a third portion (186e) of the second side electrode (186c) corresponding to the connecting portion of the substrate (187) is disposed on the first side of the substrate (187), and the second portion and the third portion (186e) of the second side electrode (186c) are electrically connected through the fourth contact hole.

7. The back light unit of any one of claims 4 to 6, wherein the connecting portion is disposed at an angle with respect to the projecting portion.

8. The back light unit of claim 7, wherein the angle is about 90 degrees.

9. The back light unit of any one of claims 1 to 8, wherein the projecting portion is disposed at an angle of about 90 degrees with respect to the main portion.

10. A Liquid Crystal Display Device comprising a liquid crystal panel (150); and a back light unit according to any one of claims 1 to 9 supporting the liquid crystal panel (150) and irradiating light toward the liquid crystal panel (150).

## Patentansprüche

1. Hintergrundbeleuchtungseinheit, aufweisend:
ein Führungspanel (140), von dem eine seitliche Seite vollständig offen ist und eine untere Seite offen ist,
ein Lichtleitpanel (120), das in dem Führungspanel (140) angeordnet ist,
einen Abdeckboden (110), der konfiguriert ist, um das Führungspanel (140) abzustützen, und
ein Lichtquellenmodul (180), das an der seitlichen Seite des Führungspanels (140) angeordnet ist und Licht in Richtung zu einer Seite des Lichtleitpanels (120), die an der seitlichen Seite des Führungspanels (140) angeordnet ist, ausstrahlt,
wobei das Führungspanel (140) konfiguriert ist, um zum Führen des Lichtquellenmoduls (180) zu dienen,
wobei das Lichtquellenmodul (180) aufweist:
mindestens eine Lichtquelle (182), die Licht emittiert, und
eine flexible Leiterplatte (181), auf der die Lichtquelle (182) platziert ist, aufweisend:
ein Substrat (187), das aus einem flexiblen Material hergestellt ist,
eine erste Elektrode (185a), die auf einer ersten Seite des Substrats (187) angeordnet ist,
eine zweite Elektrode (186a), die auf der ersten Seite des Substrats (187) angeordnet und mit der ersten Elektrode (185a) verbunden ist,
eine erste Seitenelektrode (185c), die auf einer zweiten Seite des Substrats (187) angeordnet ist und mit der ersten Elektrode (185a) durch ein in dem Substrat (187) ausgebildetes erstes Kontaktloch (185b) verbunden ist, wobei die zweite Seite der ersten Seite gegenüberliegt, und
eine zweite Seitenelektrode (186c), die auf der zweiten Seite des Substrats (187) angeordnet und mit der zweiten Elektrode (186a) durch ein in dem Substrat (187) ausgebildetes zweites Kontaktloch (186b) verbunden ist,
wobei die erste und die zweite Elektrode (185a, 186a) der flexiblen Leiterplatte (181) mit der Lichtquelle (182) verbunden sind,
wobei das Substrat (187) einen Hauptabschnitt mit einem ersten seitlichen Ende und einem zweiten seitlichen Ende, das zu dem ersten seitlichen Ende entgegengesetzt ist, und einen hervorstehenden Abschnitt, der von dem Hauptabschnitt in der Nähe des zweiten seitlichen Endes hervorsteht, aufweist, wobei die erste Elektrode (185a) und die zweite Elektrode (186a) auf dem Hauptabschnitt angeordnet sind, wobei die erste Seitenelektrode (185c) und die zweite Seitenelektrode (186c) auf dem Hauptabschnitt und auf dem hervorstehenden Abschnitt angeordnet sind,
wobei die erste Elektrode (185a) eine Mehrzahl von Elektrodenmustern (185d) aufweist,
ein erstes Elektrodenmuster (185d1) der Elektrodenmuster (185d) am ersten seitlichen Ende des Hauptabschnitts angeordnet und mit der zweiten Elektrode (186a) verbunden ist,
ein zweites Elektrodenmuster (185d2) der Elektrodenmuster (185d) am zweiten seitlichen Ende des Hauptabschnitts angeordnet ist und mit der ersten Seitenelektrode (185c) durch das erste Kontaktloch (185b) verbunden ist, und
die zweite Seitenelektrode (186c) durch das zweite Kontaktloch (186b) mit der zweiten Elektrode (186a) verbunden ist,
wobei das zweite Elektrodenmuster (185d2) der Elektrodenmuster (185d) teilweise sowohl die erste Seitenelektrode (185c) als auch die zweite Seitenelektrode (186c) überlappt, wobei sich das Substrat (187) dazwischen befindet.

2. Hintergrundbeleuchtungseinheit gemäß Anspruch 1, ferner aufweisend eine Lichtquelle (182), die zwischen zwei benachbarten Elektrodenmustern (185d) der Mehrzahl von Elektrodenmustern (185d) angeordnet ist.

3. Hintergrundbeleuchtungseinheit gemäß Anspruch 1, ferner aufweisend eine Mehrzahl von Lichtquellen (182), wobei jede Lichtquelle (182) zwischen zwei jeweiligen benachbarten Elektrodenmustern der Mehrzahl von Elektrodenmustern (185d) angeordnet ist, und ein Lichtabschirmpad zum Abschirmen von Licht, das zwischen mindestens zwei Lichtquellen (182) der Mehrzahl von Lichtquellen (182) angebracht ist.

4. Hintergrundbeleuchtungseinheit gemäß irgendeinem der Ansprüche 1 bis 3, wobei das Substrat (187) ferner einen Verbindungsabschnitt aufweist, der konfiguriert ist, um mit einem externen Anschluss verbunden zu werden, und mit dem hervorstehenden Abschnitt verbunden ist, wobei sich die erste Seitenelektrode (185c) und die zweite Seitenelektrode (186c) von dem Hauptabschnitt über den hervorstehenden Abschnitt bis zu einem Ende des Verbindungsabschnitts erstrecken.

5. Hintergrundbeleuchtungseinheit gemäß Anspruch 4, wobei der Verbindungsabschnitt ein drittes Kontaktloch (185f) und ein viertes Kontaktloch (186c) aufweist, wobei die erste Seitenelektrode (185c) von der zweiten Seite des Substrats (187) aus durch das dritte Kontaktloch (185f) mit der ersten Seite des Substrats (187) verbunden ist, und wobei die zweite Seitenelektrode (186c) von der zweiten Seite des Substrats (187) aus durch das vierte Kontaktloch (186f) mit der ersten Seite des Substrats (187) verbunden ist.

6. Hintergrundbeleuchtungseinheit gemäß Anspruch 4 oder 5, wobei ein erster und ein zweiter Abschnitt der ersten Seitenelektrode (185c), die mit dem Hauptabschnitt bzw. dem hervorstehenden Abschnitt des Substrats (187) korrespondieren, auf der zweiten Seite des Substrats (187) angeordnet sind, ein dritter Abschnitt (185e) der ersten Seitenelektrode (185c), der mit dem Verbindungsabschnitt des Substrats (187) korrespondiert, auf der ersten Seite des Substrats (187) angeordnet ist, und der zweite Abschnitt und der dritte Abschnitt (185e) der ersten Seitenelektrode (185c) durch das dritte Kontaktloch elektrisch verbunden sind, und
wobei ein erster und ein zweiter Abschnitt der zweiten Seitenelektrode (186c), die mit dem Hauptabschnitt bzw. dem hervorstehenden Abschnitt des Substrats (187) korrespondieren, auf der zweiten Seite des Substrats (187) angeordnet sind, ein dritter Abschnitt (186e) der zweiten Seitenelektrode (186c), der mit dem Verbindungsabschnitt des Substrats (187) korrespondiert, auf der ersten Seite des Substrats (187) angeordnet ist, und der zweite Abschnitt und der dritte Abschnitt (186e) der zweiten Seitenelektrode (186c) durch das vierte Kontaktloch elektrisch verbunden sind.

7. Hintergrundbeleuchtungseinheit gemäß irgendeinem der Ansprüche 4 bis 6, wobei der Verbindungsabschnitt in einem Winkel in Bezug auf den hervorstehenden Abschnitt angeordnet ist.

8. Hintergrundbeleuchtungseinheit gemäß Anspruch 7, wobei der Winkel etwa 90 Grad beträgt.

9. Hintergrundbeleuchtungseinheit gemäß irgendeinem der Ansprüche 1 bis 8, wobei der hervorstehende Abschnitt in einem Winkel von etwa 90 Grad in Bezug auf den Hauptabschnitt angeordnet ist.

10. Flüssigkristallanzeigevorrichtung, aufweisend ein Flüssigkristallpanel (150) und eine Hintergrundbeleuchtungseinheit gemäß irgendeinem der Ansprüche 1 bis 9, die das Flüssigkristallpanel (150) abstützt und Licht in Richtung zu dem Flüssigkristallpanel (150) ausstrahlt.

## Revendications

1. Unité de rétroéclairage comprenant :
un panneau de guidage (140) dont un côté latéral est complètement ouvert, et un côté inférieur est ouvert ;
un panneau de guidage de la lumière (120) agencé dans le panneau de guidage (140) ;
un fond de couvercle (110) configuré pour supporter le panneau de guidage (140), et
un module source de lumière (180) agencé au niveau du côté latéral du panneau de guidage (140), et qui irradie une lumière vers un côté du panneau de guidage de la lumière (120) agencé au niveau du côté latéral du panneau de guidage (140),
dans laquelle le panneau de guidage (140) est configuré pour servir à guider le module source de lumière (180),
dans laquelle le module source de lumière (180) comprend :
au moins une source de lumière (182) qui émet une lumière ; et
une carte de circuit imprimé souple (181) sur laquelle est placée la source de lumière (182), comprenant :
un substrat (187) réalisé dans un matériau souple ;
une première électrode (185a) agencée sur un premier côté du substrat (187) ;
une seconde électrode (186a) agencée sur le premier côté du substrat (187), et connectée à la première électrode (185a) ;
une première électrode latérale (185c) agencée sur un second côté du substrat (187), et connectée à la première électrode (185a) par un premier trou de contact (185b) formé dans le substrat (187), dans laquelle le second côté est opposé au premier côté ; et
une seconde électrode latérale (186c) agencée sur le second côté du substrat (187), et connectée à la seconde électrode (186a) par un deuxième trou de contact (186b) formé dans le substrat (187),
dans laquelle les première et seconde électrodes (185a, 186a) de la carte de circuit imprimé souple (181) sont connectées à la source de lumière (182),
dans laquelle le substrat (187) comprend une partie principale qui présente une première extrémité latérale et une seconde extrémité latérale opposée à la première extrémité latérale, et une partie en saillie qui fait saillie à partir de la partie principale, à proximité de la seconde extrémité latérale, dans laquelle la première électrode (185a) et la seconde électrode (186a) sont disposées sur la partie principale, dans laquelle la première électrode latérale (185c) et la seconde électrode latérale (186c) sont disposées sur la partie principale et sur la partie en saillie,
dans laquelle la première électrode (185a) comprend une pluralité de motifs d'électrodes (185d),
un premier motif d'électrode (185d1) des motifs d'électrode (185d), est agencé au niveau de la première extrémité latérale de la partie principale, et est connecté à la seconde électrode (186a),
un second motif d'électrode (185d2) des motifs d'électrode (185d), est agencé au niveau de la seconde extrémité latérale de la partie principale, et est connecté à la première électrode latérale (185c) par le premier trou de contact (185b), et
la seconde électrode latérale (186c) est connectée à la seconde électrode (186a) par le second trou de contact (186b),
dans laquelle le second motif d'électrode (185d2) des motifs d'électrode (185d) chevauche en partie la première électrode latérale (185c) et la seconde électrode latérale (186c), le substrat (187) se situant entre.

2. Unité de rétroéclairage selon la revendication 1, comprenant en outre une source de lumière (182) disposée entre deux motifs d'électrodes adjacents (185d) de la pluralité de motifs d'électrode (185d).

3. Unité de rétroéclairage selon la revendication 1, comprenant en outre une pluralité de sources de lumière (182), chaque source de lumière (182) étant disposée entre deux motifs d'électrodes adjacents respectifs de la pluralité de motifs d'électrode (185d), et une plaquette de protection vis-à-vis de la lumière, est fixée entre deux sources de lumière (182) au moins de la pluralité de sources de lumière (182).

4. Unité de rétroéclairage selon l'une quelconque des revendications 1 à 3, dans laquelle le substrat (187) comprend en outre une partie connexion configurée pour être connectée à une borne extérieure, et pour être connectée à la partie en saillie, dans laquelle la première électrode latérale (185c) et la seconde électrode latérale (186c) s'étendent à partir de la partie principale par l'intermédiaire de la partie en saillie, vers une extrémité de la partie connexion.

5. Unité de rétroéclairage selon la revendication 4, dans laquelle la partie connexion comprend un troisième trou de contact (185f) et un quatrième trou de contact (186c), dans laquelle la première électrode latérale (185c) est connectée à partir du second côté du substrat (187) vers le premier côté du substrat (187) par le troisième trou de contact (185f), et dans laquelle la seconde électrode latérale (186c) est connectée à partir du second côté du substrat (187) vers le premier côté du substrat (187) par le quatrième trou de contact (186f).

6. Unité de rétroéclairage selon la revendication 4 ou 5,
dans laquelle les première et seconde parties de la première électrode latérale (185c) correspondant à la partie principale et à la partie en saillie du substrat (187), respectivement, sont disposées sur le second côté du substrat (187), une troisième partie (185e) de la première électrode latérale (185c) correspondant à la partie connexion du substrat (187) est disposée sur le premier côté du substrat (187), et la seconde partie et la troisième partie (185e) de la première électrode latérale (185c) sont connectées électriquement par le troisième trou de contact ; et
dans laquelle les première et seconde parties de la seconde électrode latérale (186c) correspondant à la partie principale et à la partie en saillie du substrat (187), respectivement, sont disposées sur le second côté du substrat (187), une troisième partie (186e) de la seconde électrode latérale (186c) correspondant à la partie connexion du substrat (187) est disposée sur le premier côté du substrat (187), et la seconde partie et la troisième partie (186e) de la seconde électrode latérale (186c) sont connectées électriquement par le quatrième trou de contact.

7. Unité de rétroéclairage selon l'une quelconque des revendications 4 à 6, dans laquelle la partie connexion est disposée sous un certain angle par rapport à la partie en saillie.

8. Unité de rétroéclairage selon la revendication 7, dans laquelle l'angle est approximativement égal à 90 degrés.

9. Unité de rétroéclairage selon l'une quelconque des revendications 1 à 8, dans laquelle la partie en saillie est disposée sous un angle approximativement égal à 90 degrés par rapport à la partie principale.

10. Dispositif d'affichage à cristaux liquides comprenant un panneau à cristaux liquides (150), et une unité de rétroéclairage selon l'une quelconque des revendications 1 à 9, qui supporte le panneau à cristaux liquides (150), et qui irradie une lumière vers le panneau à cristaux liquides (150).
